(19)

Europäisches
Patentamt
European
Patent Office
Office européen
des brevets

(11) **EP 4 307 189 A1**

(12) **EUROPEAN PATENT APPLICATION**

(43) Date of publication:
 **17.01.2024 Bulletin 2024/03**

(21) Application number: **23184278.2**

(22) Date of filing: **07.07.2023**

(51) International Patent Classification (IPC):
 **G06Q 10/04** *(2023.01)* **G06Q 10/063** *(2023.01)*

(52) Cooperative Patent Classification (CPC):
 **G06Q 10/04; G06Q 10/063;** Y02P 90/84

(84) Designated Contracting States:
 **AL AT BE BG CH CY CZ DE DK EE ES FI FR GB
 GR HR HU IE IS IT LI LT LU LV MC ME MK MT NL
 NO PL PT RO RS SE SI SK SM TR**
 Designated Extension States:
 **BA**
 Designated Validation States:
 **KH MA MD TN**

(30) Priority: **15.07.2022 HK 32022056815**

(71) Applicant: **Mother Nature Resources Limited
 Central, Hong Kong (HK)**

(72) Inventor: **YIP, Stanley Cho Tat
 Central, Hong Kong (HK)**

(74) Representative: **Beck & Rössig
 European Patent Attorneys
 Denninger Str. 169
 81925 München (DE)**

(54) **SYSTEM AND METHOD FOR SIMULATING AND PREDICTING FORECASTS FOR CARBON
 EMISSIONS**

(57) The present invention discloses an integrated and comprehensive carbon accounting system (100) for simulating and predicting forecasts for carbon emissions of an emission entity of urban development projects, real estate assets and buildings, characterized by: a data collection module (108) for collecting a plurality of data; wherein the plurality of data comprises a plurality of activity data (AD) (104), a plurality of emission factors (EF) (106), data relating to a plurality of observed dependent variables and a plurality of observed independent variables for prediction; a carbon accounting module (102) for calculating carbon emissions (105) of the plurality of emission entities based on the plurality of activity data (AD) (104) and the plurality of emission factors (EF) (106); wherein the carbon accounting module (102) comprises a carbon emission sub-module, a carbon-off setting sub-module and a carbon avoidance sub-module; wherein the carbon accounting module (102) covers a plurality of Scope 1, Scope 2 and Scope 3 emissions; a predictive analytical modelling module (110) for generating simulation and predictive forecast models based on a plurality of observed dependent variables and the plurality of observed independent variables; a simulative forecast module (112) for predicting and forecasting a level of future carbon emissions and emission pathways and trends over timelines based on the data collection module (108) and the predictive analytical modelling module (110); wherein the level of future carbon emissions and emission pathways and trends over timelines are predicted and forecasted according to a plurality of predetermined scenarios for the plurality of emission entities with respect to pre-set mitigation measures, target amount, target years which are defined by users; and a key performance indicators and metrics module (114) for evaluating performance of the simulative forecast module.

FIG. 1

**Description**

FIELD OF THE INVENTION

The present invention relates to a system and method for simulating and predicting forecasts for carbon emissions, in particularly an integrated and comprehensive carbon accounting system for simulating and predicting forecasts of carbon emissions from emissions entities of urban development projects, real estate assets and buildings.

BACKGROUND OF THE INVENTION

Carbon accounting is a process used to measure the quantity of greenhouse gas emitted by an emission entity (EE). Carbon emission accounting and data analytics provides a crucial scientific and business basis to support the making of investment, project planning and design, construction, property management decisions and carbon disclosure for urban development projects, real estate assets and buildings. Managing the emissions from these emission entities (EE) is a key decision making and focus of carbon mitigation by governments, financial institutions, enterprises, property owners, tenants, service providers and the communities.

Consequently, there is high importance to analyse and forecast carbon emissions mitigation performance from the above-mentioned emission entities. However, the existing carbon accounting tools for the emissions entities for urban development, real estate assets and buildings primarily focus on auditing carbon emissions based on historical performance or focus on estimating the emissions associated with a design scheme at the planning and design phase of a project. Such existing accounting methodology may not be able to accurately simulate and forecast future carbon emissions mitigation performance for real-life scenarios during the full life cycle of the emission entities particularly at their operational stage to monitor their pathways to achieving specific mitigation targets.

Also, the existing carbon accounting tools which only use conventional, historical and reported activity data for auditing past performance may not produce effective future forecasts. Hence, there is a need to construct effective, efficient analytical models for simulating and predicting forecasts of carbon emissions based on a comprehensive sources of real time IOT data, big data, user behaviours data and built form data in addition to the conventional historical and reported activity data.

China Patent No.113592187A discloses an intelligent carbon emission management system and method, which can predict the amount of carbon emission and assist carbon emission index trading according to the prediction result. The system generates predicted carbon emission based on the carbon emission data and emission reduction data, and compare the predicted carbon emission and carbon emission indicators to generate judgement results. However, the system and method are only limited to the carbon emission prediction for company or industrial enterprises. This may lack the scalability of the application to cover urban development, real estate assets and buildings emission entities at different spatial scales such as city districts, industrial parks, business parks, science parks, campus, neighbourhoods and buildings. Therefore, there is a need to have an integrated and comprehensive carbon accounting system for simulating and predicting forecasts of carbon emissions from emissions entities of urban development projects, real estate assets and buildings.

United States Patent No. 20200372588 A1 discloses a methods and systems for machine-learning for prediction of grid carbon emissions. The artificial intelligence and machine-learning methods are used to estimate real-time emission impacts based on grid data. Deep learning for real-time or online optimization and control may be used to minimize emission impacts while maximizing efficiency benefits under uncertainties of the ambient environment and user behaviors. A result may be a real-time data-driven software platform that implements methods and provides intuitive, compelling real-time visualizations. However, the methods and systems only disclose grid carbon emission which regards to emission of atmospheric carbon due to production and/or consumption of electrical energy in an electrical power grid. It does not include other carbon emission, carbon off-set and carbon avoidance sources. Therefore, there is a need to have an integrated and comprehensive carbon accounting system for simulating and predicting forecasts of carbon emissions from emissions entities of urban development proj ects, real estate assets and buildings.

China Patent No. 111445060 A discloses a community carbon emission monitoring and predicting system and method. The system is used to solve the problem of community carbon emission accounting difficulties, measure the level of community low-carbon construction and provide a reference for formulating community energy-saving and carbon-reduction measures. The community carbon emission activity data includes residential area, community public area, community waste treatment, wastewater treatment, and the residential area consumption, data generated by electricity generation, consumption of natural gas, gasoline consumption, and diesel consumption data, community consumption and other energy carbon emissions data. However, the emissions account only the Scopes 1 and Scope 2 emissions but has not included the Scope 3 emissions which are important indirect emissions. Therefore, there is a need to have an integrated and comprehensive carbon accounting system for simulating and predicting forecasts of carbon emissions from emissions entities of urban development projects, real estate assets and buildings.

SUMMARY OF THE INVENTION

It is an objective of the present invention to provide an integrated and comprehensive carbon accounting system for simulating and predicting forecasts of carbon emissions from emissions entities of urban development projects, real estate assets and buildings.

It is also an objective of the present invention to provide a system and method which can generate future forecast of emissions based on predetermined scenarios, test the impacts of different emission mitigation actions, and evaluate the carbon mitigation performance based on a system of key performance indicators and metrics.

Accordingly, these objectives may be achieved by following the teachings of the present invention. The present invention relates to an integrated and comprehensive carbon accounting system for simulating and predicting forecasts of carbon emissions from emissions entities of urban development projects, real estate assets and buildings, characterized by: a carbon accounting modules for calculating carbon emissions based on activity data (AD) and emission factors (EF); wherein the carbon accounting module comprises a carbon emission sub-module, a carbon-off setting sub-module and a carbon avoidance sub-module that covers Scope 1, Scope 2 and Scope 3 emissions; a data collection module for collecting the activity data (AD), emission factors, historical, observed data of dependent variables and independent variables for simulative prediction; a predictive analytical modelling module for generating simulation and predictive forecast models on future carbon emissions based on the historical and observed data of dependent and independent variables; a simulative forecast module for predicting the level of future carbon emissions based on the data collection module and the predictive analytical model module; a system of key performance indicators and metrics for quantified evaluation of the performance.

BRIEF DESCRIPTION OF THE DRAWINGS

The features of the invention will be more readily understood and appreciated from the following detailed descriptions when read in conjunction with the accompanying drawings of the preferred embodiment of the present invention, in which:

FIG. 1 illustrates an integrated and comprehensive carbon accounting system in the present invention;
FIG. 2 illustrates a carbon accounting module for calculating carbon emissions;
FIG. 3 illustrates a flowchart of method to generate simulative and predictive forecast models in a predictive analytical modelling module;
FIG. 4 illustrates a flowchart of method to test future emission scenarios in a simulative forecast module.

DETAILED DESCRIPTION OF THE PREFERRED EMBODIMENT

For the purposes of promoting and understanding of the principles of the invention, reference will now be made to the embodiments illustrated in the drawings and described in the following written specification. It is understood that the present invention includes any alterations and modifications to the illustrated embodiments and includes further applications of the principles of the invention as would normally occur to one skilled in the art to which the invention pertains.

The present invention teaches an integrated and comprehensive carbon accounting system 100 for simulating and predicting forecasts for carbon emissions of an emission entity, characterized by: a data collection module 108 for collecting a plurality of data; wherein the plurality of data comprises a plurality of activity data (AD) 104, a plurality of emission factors (EF) 106, data relating to a plurality of observed dependent variables and a plurality of observed independent variables; a carbon accounting module 102 for calculating carbon emissions 105 of the plurality of emission entities based on the plurality of activity data (AD) 104 and the plurality of emission factors (EF) 106; wherein the carbon accounting module 102 comprises a carbon emission sub-module, a carbon-off setting sub-module and a carbon avoidance sub-module; wherein the carbon accounting module 102 covers a plurality of Scope 1, Scope 2 and Scope 3 emissions; a predictive analytical modelling module 110 for generating simulation and predictive forecast models based on a plurality of observed dependent variables and the plurality of observed independent variables; a simulative forecast module 112 for predicting and forecasting a level of future carbon emissions and emission pathways and trends over timelines based on the data collection module 108 and the predictive analytical modelling module 110; wherein the level of future carbon emissions and emission pathways and trends over timelines are predicted and forecasted according to a plurality of predetermined scenarios for the plurality of emission entities with respect to pre-set mitigation measures, target amount, target years which are defined by users; and a key performance indicators and metrics module 114 for evaluating performance of the simulative forecast module.

In a preferred embodiment of the present invention, the emission entities are urban development projects, real estate assets and buildings, including but not limited to city districts, industrial parks, business parks, science parks, campus and neighbourhoods, individual and clusters of buildings.

In a preferred embodiment of the present invention, the carbon emissions sub-module comprises building operational energy, building embodied energy, mobility and transportation, solid waste, water resources, wastewater and sewage, industrial and manufacturing activities, public facilities and street lighting.

In a preferred embodiment of the present invention, the carbon accounting module 102 for calculating carbon emissions includes eight carbon emission sub-modules, one carbon-off setting sub-module and one carbon avoidance sub-module. Said modules are calculation methods based on the formula below:

$$C = \sum C_i = \sum \text{Activity Data i (AD}_i) \times \text{Emission Factor i (EF}_i) \qquad \ldots\ldots\ldots \quad (1)$$

where:

C is the total Carbon Emissions of the emission entity in term of $CO_2$ equivalent ($CO_2e$);

$C_i$ is the amount of carbon emission, off-set or avoidance of Activity Data i (Activity as represented by the 10 Activity Modules);

Activity Data i ($AD_i$) is a quantitative measure of the level of Activity i that results in carbon emissions, off-set or avoidance;

Emission Factor i ($EF_i$) is a factor that converts Activity Data i ($AD_i$) into positive or negative carbon emissions (for carbon emission the EF takes a +ve sign; for offset and avoidance, the EF takes a -ve sign).

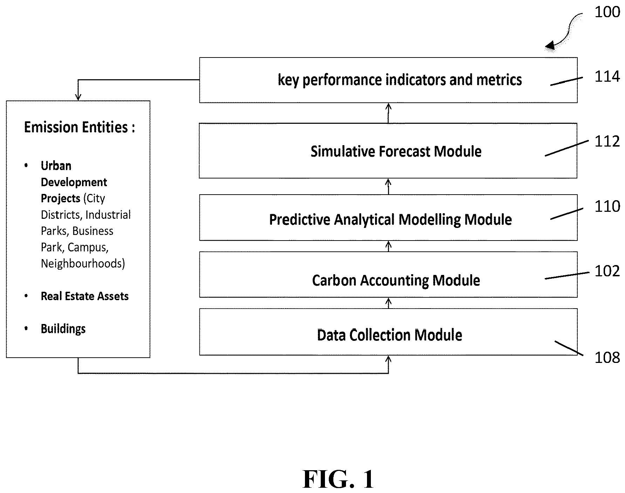

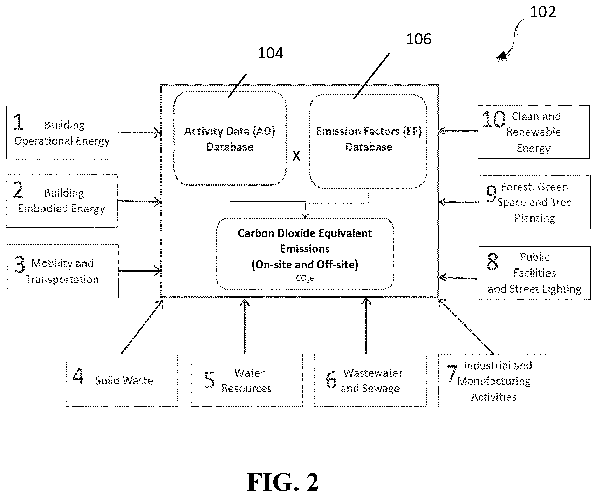

FIG. 1 illustrates an integrated and comprehensive carbon accounting system in the present invention and FIG. 2 illustrates a carbon accounting module for calculating carbon emissions.

In a preferred embodiment of the present invention, the eight carbon emission sub-modules comprise building operational energy, building embodied energy, mobility and transportation, solid waste, water resources, wastewater and sewage, industrial and manufacturing activities, public facilities and street lighting. The one carbon-off setting sub-module comprises forest, green space and tree planting. The one carbon avoidance sub-module comprises renewable energy.

In a preferred embodiment of the present invention, the carbon accounting module 102 includes on-site and off-site direct and indirect Scope 1, Scope 2 and Scope 3 emissions.

Scope 1 emissions are direct emissions from sources and removals by carbon sinks the EE controls within the physical boundary. These include (a) combustion of fuels in stationary sources (excluding electrical equipment) to generate electricity, heat, or steam. For example: electricity generators, boilers, gas cooking stoves, etc. and (b) combustion of fuels in mobile sources (mobile energy such as motor vehicles) controlled by the reporting EE to and/or from the EE concerned or used within the physical boundary of the EE. For example, the local shuttle bus services are within the physical boundaries of the EE.

Scope 2 emissions are indirect energy emissions that generated from purchased electricity and/or gas that is consumed by the EE controlled equipment or its operations within the physical boundary.

Scope 3 emissions are other indirect emissions. These include (a) greenhouse gases (GHG) emissions at landfill due to disposal of waste from the EE; (b) GHG emissions due to electricity and energy used for water supply, drainage, waste water treatment; (c) building embodied carbon from building material extraction and production, transportation, construction and demolition; (d) transportation and trips of cross-boundary passengers and goods into and from within the physical boundaries of the EE generated by the operation of the EE as an origin or destination for the trips (for example, employee trips to work, residents trips to work, leisure and shopping, business visits to companies within the EE, etc., excluding traffic not taking the EE as an origin or destination).

In a preferred embodiment of the present invention, the data collection module 108 collects data from sources of historical and reported data, surveyed data, third party reference data, real time data from the building energy management systems, property management systems, water usage monitoring systems, air quality management systems, parking management systems, and security systems, real time big data from mobile phone, GPS, Apps, and transport mobility monitoring systems via a communication protocol, and data on user behaviours and usage patterns, weather and micro-climate conditions, and building and urban district physical configurations as well as surface materials.

In a preferred embodiment of the present invention, the independent variables comprise scale factors, weather factors, economic factors, user behaviour factors, physical site and built form factors, green building and energy factors. The scale factors include but not limited to population size, number of households, number of tenants, site area and building gross floor area. The weather factors include but not limited to humidity, average temperature, rainfall, heat waves, snowstorm, air quality and extreme weather. The economic factors include but not limited to occupancy rate, vacancy, rental levels, property valuation, building construction cost, industry output and business nature of tenants or users. The user behaviour factors include but not limited to traffic low, pedestrian flow, operational hours, space or facilities usage patterns and user socio-economic profiles. The physical site and built form factors include but not limited to street network density, open space coverage or ratio, open space breezeways, building window orientation, building facade-window ratios, built form and shape, building height, building material, age of buildings and parking spaces. The green building and energy factors include but not limited to green building certification levels, building energy saving design standards, percentage of renewable or clean energy usage, energy usage time-series patterns and historical trends.

In a preferred embodiment of the present invention, the observed dependent variables comprise historically recorded and observed carbon emissions of the emission entities over defined time-series patterns and historical trends.

In a preferred embodiment of the present invention, the predictive analytical modelling module 110 generates simulation and predictive forecast models on future carbon emissions based on the historical and observed data of dependent and independent variables.

In a preferred embodiment of the present invention, the predictive analytical modelling module 110 includes the basic model structure of the relationship between the variables as follows:

$$C = f(S, W, E, U, P, G) \dots\dots\dots\dots\dots\dots\dots (2)$$

wherein

C is the dependent variable of carbon emissions generated by the emission entity (EE),
$f$ is the function,
S is scale factors,
W is weather factors,
E is economic factors,
U is user behaviour factors,
P is physical site and built form factors, and
G is green building and energy factors.

The forecast for each of the carbon modules include linear and non-linear multi-variate regression functions with logarithmic and semi-logarithmic forms:

$$Ln\,(C) = a_0 + \Sigma_{\,n=1}\, a_i\, Ln\,(Z_i) + \varepsilon \quad \dots\dots\dots\dots\dots\dots\dots(3)$$

$$Ln\,(C) = a_0 + \Sigma_{\,n=1}\, a_i Z_i + \varepsilon \quad \dots\dots\dots\dots\dots\dots\dots(4)$$

wherein

$Z_i$ denotes independent variables,
$a_0$ denotes a constant,
ai denotes regression coefficients, and
$\varepsilon$ is the residual error term.

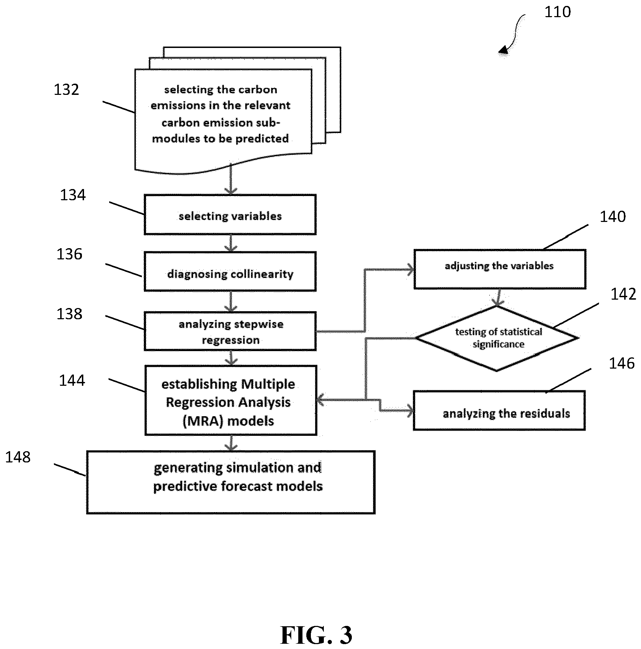

A method of generating simulation and predictive forecast models in the predictive analytical modelling module 110 is illustrated in FIG.3. The method comprises the steps of: selecting a carbon emissions from a relevant carbon emission sub-modules for prediction 132; selecting variables 134 which are relevant to the activity data (AD) 104 in the carbon emissions sub-modules; diagnosing collinearity 136 for the selected variables; analysing stepwise regression 138 by adjusting 140 and testing of statistical significance 142 for the selected variables; and establishing a Multiple Regression Analysis (MRA) models 144; wherein residuals are analysed 146 in the MRA models.

In a preferred embodiment of the present invention, the simulative forecast module 112 predicts the level of future carbon emissions comprising volume, intensity and trends for a specified time period. Said specified time period comprises real time, daily, weekly, monthly and yearly.

In a preferred embodiment of the present invention, the simulative forecast module 112 predicts the level of future carbon emissions based on different scenarios comprising Business-as-Usual (BAU) scenario, low carbon scenario, carbon peaking scenario and carbon neutral scenario, and any other pre-set scenarios with quantified emission mitigation targets.

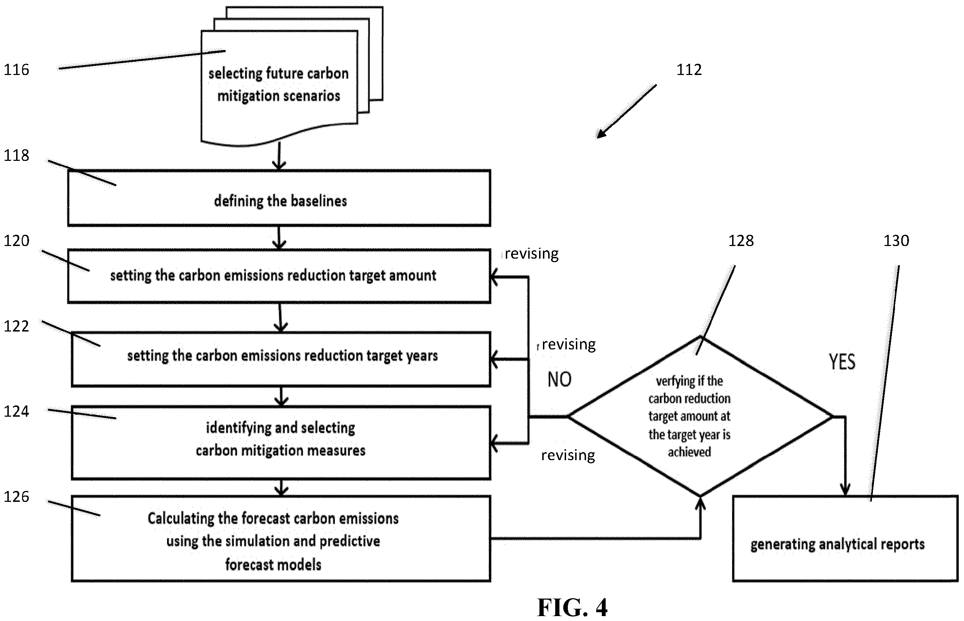

FIG. 4 illustrates a flowchart of method to test future emission scenarios in the simulative forecast module. The method comprises the steps of: selecting a future carbon mitigation scenario 116; defining a baseline 118 for the selected future carbon mitigation scenario; setting a carbon emissions reduction target amount 120 and a carbon emissions reduction target year 122; identifying and selecting a carbon mitigation measures 124; calculating the forecast carbon emissions 126 using the plurality of simulation and predictive forecast models; verifying if the carbon reduction target amount at the target year is achieved 128; and generating an analytical report 130 on emission levels, emission intensities, emission by sources or by sub-modules, emission pathways and trends over timelines, comparisons of different future carbon mitigation scenarios; revising the carbon emissions reduction target amount and the carbon emissions reduction target year; re-identifying and re-selecting a carbon mitigation measures; and re-calculating the forecast carbon emission based on a re-identified and re-selected carbon mitigation measures to regenerate an analytical report.

The mitigation measures for building operational energy include setting higher building energy saving standard over and above the current statutory building design standard with additional reduction (including but not limited to by 10%, 20%, 30% or 40% energy saving).

The mitigation measures for building embodied energy such as measures for design and construction stages comprises setting up a reduction of the embodied carbon of the reference value (including but not limited to by 10%, 20% or 30%). Said reference value refers to local industry standards or government standards.

The mitigation measures for mobility and transportation include adopting transport-oriented development in urban form (including but not limited to with a percentage of building floor area within 500m exceeding 100%); high accessibility to public transport services with distance from site to the nearest public transport service (including but not limited to less than 100m; increasing residents or visitors green trips ratio (including but not limited to 70%, 60% or 50%); increasing electric vehicles trips percentages (including but not limited to 20%, 15%, 10% or 5%). The mitigation options for solid waste include increasing the waste to energy ratio (including but not limited to 100%, 90%, 80%, 50% or 20%); reduction of solid waste volume (including but not limited to 5%, 10%, 15% or 20%.

The mitigation measures for water resources include reduction of water conservation such as portable water usage volume (including but not limited to 5%, 10%, 15% or 20%; reducing the rate of per capita water consumption from baseline by (including but not limited to 5%, 10%, 15% or 20%.

The mitigation measures for wastewater and sewage comprise increasing the sewage to energy ratio (including but not limited to 100%, 90%, 80%, 50% or 20%) ; reducing wastewater volume (including but not limited to by 5%, 10%, 15% or 20%).

The mitigation measures for industrial and manufacturing activities comprise increasing service industry GDP ratio from baseline (including but not limited to 10%, 20%, 30% or 40%); reducing energy consumption per unit of industrial GDP and/or value add from baseline (including but not limited to 10%, 15%, 20%, 25%, or 30%); reducing industrial process energy consumption saving (including but not limited to 5%, 10%, 15%, 20% or 30%); increasing on-site clean or renewable energy consumption (including but not limited to 5%, 10%, 15% or 20%. The mitigation options for public facilities and street lighting comprise an increasing percentage of lighting using LED and/or renewable electricity (including but not limited to 100%, 90% or 80%).

The mitigation measures for forest, green space and tree planting comprise increasing vegetation coverage ratio (including but not limited to 40%, 45%, 50%, 55% or 60%). The mitigation options for renewable energy comprises increasing renewable energy consumption on-site (including but not limited to 5%, 10%, 15%, 20% or 25%);

The mitigation measures for renewable energy comprise increasing renewable energy usage levels for hot water supply (including but not limited to to 20%, 30%, 50% or 70%); and increase renewable energy usage level for electricity supply (including but not limited to to 5%, 10%, 15% or 20%); increasing off-site renewable energy production projects and programmes from baseline (including but not limited to 5%, 10%, 15%, 20%, 25%, 30%, 40% or 50%); purchase of renewable energy certificates to off-set fossil fuel electricity usage (including but not limited to 5%, 10%, 20%, 30%, 40%, 50% or 60%); purchase of voluntary certified carbon emissions reduction credits (CCER) (including but not limited to 5%, 10%, 20%, 30%, 40%, 50% or 60%).

In a preferred embodiment of the present invention, the key performance indicators and metrics module 114 for evaluation of the carbon mitigation performance has built-in calculation and benchmarking templates for evaluation against relevant and selected statutory or voluntary energy and emission targets, codes or best practices in different cities and regions. The 5 groups of built-in Key Performance Indicators templates include: Indicators for Operational and Embodied Emissions; Indicators for Real Estate Financial Portfolio; Indicators for Property Management and Green Lease; Indicators for Certified Carbon Emission Reduction (CCER); and Indicators for Spatial Planning, Urban Planning and Urban Design.

The built-in Key Performance Indicators for Operational and Embodied Emissions include: Gross total annual, monthly and weekly operational emissions; Emissions by sources (emissions generated, removed or offset, avoided) for the 10 Sub-Modules in the Carbon Accounting module; Emissions/Unit site area; Emissions/Unit building gross floor area; Emissions/Capita (employees, residents, visitors); Emissions/Unit rental income; Emission/Unit land value; Embodies carbon/ Unit building gross floor area; and Embodied carbon/Unit construction cost.

The built-in Key Performance Indicators for Real Estate Financial Portfolio Indicators include: Generated Emissions (an amount of carbon emissions generated in the real estate portfolio financed by loans or investment by a financial institution or an investor or a real estate enterprise); Emissions Removal and Offset (an amount of carbon emissions removed or offset in the real estate portfolio financed by loans or investment by a financial institution or an investor or a real estate enterprise); and Emissions Avoided (an amount of carbon emissions avoided in the real estate portfolio financed by loans or investment by a financial institution or an investor or a real estate enterprise). The metrics of Generated Emissions include: Gross Portfolio Emissions from the gross total annual and monthly emissions; Financed Emission from the calculation by adjusting the Gross Portfolio Emissions based on Attribution Factor reflecting outstanding percentage of loan or investment in the total value; Portfolio Emission Intensity from the calculation of the Gross Emissions divided by the loan and investment monetary amount; Asset Physical Emission Intensity from the calculation of the Gross Emissions divided by the gross floor area of the buildings and/or property site area of the assets; and Overall Emissions Exposure from the calculation of the Total Gross Annual Emissions of all the portfolios of a company (the financial institution or an investor or a real estate enterprise) divided by the total annual company revenue or income.

The built-in Key Performance Indicators for Property Management and Green Lease include Landlord Performance Indicators and Tenant Performance Indicators. The Landlord Performance Indicators include: Gross property total annual and monthly emissions from energy consumption, water consumption, waste; and Emissions breakdown from building major mechanical and electrical systems including air conditioning, ventilation, lighting, elevators and movers, appliances and electronics etc. The Tenant Performance Indicators include: Gross rented area total annual and monthly emissions from energy consumption, water consumption, waste.

The built-in Key Performance Indicators for Certified Carbon Emission Reduction (CCER) include: Energy efficiency measures in thermal applications of non-renewable biomass; Distribution of efficient light bulbs to households; Solar water heating system; Biogas/biomass thermal applications for households/small users; Efficiency and HFC-134a Recovery in Residential Refrigerators; Demand-side activities for efficient outdoor and street lighting technologies; Solar cookers for households; Dissemination of energy efficient household appliances; Energy efficiency and renewable energy measures in new residential buildings; Energy efficiency technologies and fuel switching in new buildings; Mechanical energy for the user with or without electrical energy; Thermal energy production with or without electricity; Switch from Non-Renewable Biomass for Thermal Applications by the User; Electricity generation by the user; Power saving through replacement by energy efficient chillers; Avoidance of methane emissions through composting; Power saving through replacement by energy efficient chillers; Energy efficiency and fuel switching measures for buildings; Demand-side activities for efficient lighting technologies; and Demand-side energy efficiency activities for specific technologies.

The built-in Key Performance Indicators for Spatial Planning, Urban Planning and Urban Design include: Activity Data/ Unit Land Use Area by different statutory land use types (including such as Residential, Commercial, Industrial, Public Facilities, Transportation, Roads, etc.); Energy Consumption/ Unit Land Use Area by different statutory land use types; Carbon Emissions/ Unit Land Use Area by different statutory land use types; Carbon Sequestration/ Unit Land Use Area; Carbon Sequestration/ Unit Green Area; Carbon Emissions/ Unit Length of Road Network; Renewable energy usage/ Unit Land Use Area; Total Annual Carbon Emissions of the Planning Area; and Total Projected Life Cycle Caron Emissions of the Planning Area over Planning Period.

The present invention explained above is not limited to the aforementioned embodiments and drawings, and it will be obvious to those having an ordinary skill in the art of the prevent invention that various replacements, deformations, and changes may be made without departing from the scope of the claims.

**Claims**

1. An integrated and comprehensive carbon accounting system (100) for simulating and predicting forecasts for carbon emissions of an emission entity, **characterized by**:

   a data collection module (108) for collecting a plurality of data;
   wherein the plurality of data comprises a plurality of activity data (AD) (104), a plurality of emission factors (EF) (106), data relating to a plurality of observed dependent variables and a plurality of observed independent variables; a carbon accounting module (102) for calculating carbon emissions (105) of the plurality of emission entities based on the plurality of activity data (AD) (104) and the plurality of emission factors (EF) (106);
   wherein the carbon accounting module (102) comprises a carbon emission sub-module, a carbon-off setting sub-module and a carbon avoidance sub-module;
   wherein the carbon accounting module (102) covers a plurality of Scope 1, Scope 2 and Scope 3 emissions;
   a predictive analytical modelling module (110) for generating simulation and predictive forecast models based on a plurality of observed dependent variables and the plurality of observed independent variables;

a simulative forecast module (112) for predicting and forecasting a level of future carbon emissions and emission pathways and trends over timelines based on the data collection module (108) and the predictive analytical modelling module (110);

wherein the level of future carbon emissions and emission pathways and trends over timelines are predicted and forecasted according to a plurality of predetermined scenarios for the plurality of emission entities with respect to pre-set mitigation measures, target amount, target years which are defined by users; and

a key performance indicators and metrics module (114) for evaluating performance of the simulative forecast module.

2. The integrated and comprehensive carbon accounting system (100) for simulating and predicting forecasts for carbon emissions according to claim 1, wherein the plurality of emission entities comprises urban development projects, real estate assets and buildings.

3. The integrated and comprehensive carbon accounting system (100) for simulating and predicting forecasts for carbon emissions according to claim 1 or 2, wherein the carbon emissions sub-module comprises building operational energy, building embodied energy, mobility and transportation, solid waste, water resources, wastewater and sewage, industrial and manufacturing activities, public facilities and street lighting.

4. The integrated and comprehensive carbon accounting system (100) for simulating and predicting forecasts for carbon emissions according to one of claims 1 to 3, wherein the carbon off-setting sub-module comprises forest, green space and tree planting.

5. The integrated and comprehensive carbon accounting system (100) for simulating and predicting forecasts for carbon emissions according to one of claims 1 to 4, wherein the carbon avoidance sub-module comprises renewable energy.

6. The integrated and comprehensive carbon accounting system (100) for simulating and predicting forecasts for carbon emissions according to one of claims 1 to 5, wherein the data collected from the data collection module (108) comprises a historical and reported data, a surveyed data, a third party reference data, a real time data from building energy management systems, property management systems, water usage monitoring systems, air quality management systems, parking management systems, security systems, a real time big data from mobile phone, GPS, Apps, transport mobility monitoring systems via a communication protocol, and a data on user behaviours and usage patterns, weather and micro-climate conditions, building and urban district physical configurations as well as surface materials.

7. The integrated and comprehensive carbon accounting system (100) for simulating and predicting forecasts for carbon emissions according to claims 1 and 6, wherein the plurality of observed independent variables comprises the data based on scale factors, weather factors, economic factors, user behaviour factors, physical site and built form factors, and green building and energy factors.

8. The integrated and comprehensive carbon account system (100) for simulating and predicting forecasts for carbon emissions according to claims 1 and 7, wherein the observed dependent variables comprise historically recorded and observed carbon emissions of the emission entities over defined time-series patterns and historical trends.

9. The integrated and comprehensive carbon accounting system (100) for simulating and predicting forecasts for carbon emissions according to one of claims 1 to 8, wherein the simulative forecast module (112) for predicting the level of future carbon emissions comprises predictions of emissions volume, intensity and trends for a specified time period.

10. The integrated and comprehensive carbon accounting system (100) for simulating and predicting forecasts for carbon emissions according to claim 9, wherein the specified time period comprises real time, daily, weekly, monthly and yearly.

11. The integrated and comprehensive carbon accounting system (100) for simulating and predicting forecasts for carbon emissions according to one of claims 1 to 10, wherein the plurality of predetermined scenarios for the emission entity comprises a Business-as-Usual (BAU) scenario, a low carbon scenario, a carbon peaking scenario and a carbon neutral scenario, and any other scenarios with quantified carbon mitigation targets.

**12.** The integrated and comprehensive carbon accounting system (100) for simulating and predicting forecasts for carbon emissions according to one of claims 1 to 11, wherein the key performance indicators and metrics module (114) comprises a plurality of built-in Key Performance Indicators templates comprising Indicators for Operational and Embodied Emissions, Indicators for Real Estate Financial Portfolio Indicators, Indicators for Property Management and Green Lease, Indicators for Certified Carbon Emission Reduction (CCER), and Indicators for Spatial Planning, Urban Planning and Urban Design.

**13.** A method of carbon accounting for simulating and predicting forecasts for carbon emissions comprises the steps of:

generating a plurality of simulation and predictive forecast models (148);
selecting a future carbon mitigation scenario (116);
defining a baseline (118) for the selected future carbon mitigation scenario;
setting a carbon emissions reduction target amount (120) and a carbon emissions reduction target year (122);
identifying and selecting a carbon mitigation measures (124);
calculating the forecast carbon emissions (126) using the plurality of simulation and predictive forecast models; and
verifying if the carbon reduction target amount at the target year is achieved (128).

**14.** The method of carbon accounting for simulating and predicting forecasts for carbon emissions according to claim 13 further comprises the steps of:

revising the carbon emissions reduction target amount and the carbon emissions reduction target year if the carbon reduction target amount at the target year is not achieved;
re-identifying and re-selecting a carbon mitigation measures; and
re-calculating the forecast carbon emission based on a re-identified and re-selected carbon mitigation measures.

**15.** The method of carbon accounting for simulating and predicting forecasts for carbon emissions according to claim 13 or 14 further comprises the step of: generating an analytical report (130) on emission levels, emission intensities, emission by sources or by sub-modules, emission pathways and trends over timelines, comparisons of different future carbon mitigation scenarios.

**16.** The method of carbon accounting for simulating and predicting forecasts for carbon emissions according to one of claims 13 to 15, wherein the step of generating a plurality of simulation and predictive forecast models (148) comprises the steps of:

selecting carbon emissions from a plurality of carbon emission sub-modules as a function for prediction (132);
selecting variables (134) which are relevant to the selected carbon emissions from the plurality of carbon emissions sub-modules;
diagnosing collinearity (136) for the selected variables;
analysing stepwise regression (138) by adjusting (140) and testing of statistical significance (142) for the selected variables; and
establishing a Multiple Regression Analysis (MRA) model (144);
wherein residuals are analysed (146) in the MRA model.

**17.** The method of carbon accounting for simulating and predicting forecasts for carbon emissions according to claim 16, wherein the plurality of carbon emission sub-modules comprises building operational energy, building embodied energy, mobility and transportation, solid waste, water resources, wastewater and sewage, industrial and manufacturing activities, public facilities and street lighting.

100

key performance indicators and metrics — 114

**Emission Entities :**

- **Urban Development Projects** (City Districts, Industrial Parks, Business Park, Campus, Neighbourhoods)

- **Real Estate Assets**

- **Buildings**

Simulative Forecast Module — 112

Predictive Analytical Modelling Module — 110

Carbon Accounting Module — 102

Data Collection Module

108

## FIG. 1

**FIG. 2**

**FIG. 3**

**116** — selecting future carbon mitigation scenarios

**118** — defining the baselines

**120** — setting the carbon emissions reduction target amount

**122** — setting the carbon emissions reduction target years

**124** — identifying and selecting carbon mitigation measures

**126** — Calculating the forecast carbon emissions using the simulation and predictive forecast models

**128** — verfying if the carbon reduction target amount at the target year is achieved

NO — revising

YES

**130** — generating analytical reports

**112**

FIG. 4

EP 4 307 189 A1

Europäisches
Patentamt

European
Patent Office

Office européen
des brevets

# EUROPEAN SEARCH REPORT

**Application Number**

EP 23 18 4278

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 111 445 060 A (SOUTH CHINA UNIV OF TECHNOLOGY ZHUHAI INSTITUTE OF MODERN INDUSTRIAL I) 24 July 2020 (2020-07-24) * pages 5, 14; claims 1-10 * | 1-12 | INV. G06Q10/04 G06Q10/063 |
| X | YANG HONGHUA ET AL: "Using system dynamics to analyse key factors influencing China's energy-related CO2 emissions and emission reduction scenarios", JOURNAL OF CLEANER PRODUCTION, ELSEVIER, AMSTERDAM, NL, vol. 320, 24 August 2021 (2021-08-24), XP086803187, ISSN: 0959-6526, DOI: 10.1016/J.JCLEPRO.2021.128811 [retrieved on 2021-08-24] * pages 3-6, 9; figures 1-9 * | 13-17 | |

**TECHNICAL FIELDS SEARCHED (IPC)**

G06Q

The present search report has been drawn up for all claims

| Place of search | Date of completion of the search | Examiner |
|---|---|---|
| Munich | 4 December 2023 | Diaz Calvo, Sonia |

EPO FORM 1503 03.82 (P04C01)

## ANNEX TO THE EUROPEAN SEARCH REPORT
## ON EUROPEAN PATENT APPLICATION NO.

EP 23 18 4278

This annex lists the patent family members relating to the patent documents cited in  the above-mentioned European search report.
The members are as contained in the European Patent Office EDP file on
The European Patent Office is in no way liable for these particulars which are merely given for the purpose of information.

04-12-2023

| Patent document cited in search report | | Publication date | Patent family member(s) | Publication date |
|---|---|---|---|---|
| CN 111445060 | A | 24-07-2020 | NONE | |

------------------------------------------------------------------------------

EPO FORM P0459

For more details about this annex : see Official Journal of the European Patent Office, No. 12/82

**REFERENCES CITED IN THE DESCRIPTION**

**Patent documents cited in the description**

- CN 113592187 A
- US 20200372588 A1
- CN 111445060 A